# EUROPEAN PATENT SPECIFICATION

(11) **EP 0 680 624 B1**
(45) Date of publication and mention of the grant of the patent: **19.03.1997**
(21) Application number: 94903609.9
(22) Date of filing: 13.12.1993
(51) Int. Cl.: G03F 1/14, G03F 7/09

(54) **PHASE SHIFTING MASK STRUCTURE WITH ABSORBING/ATTENUATING SIDEWALLS FOR IMPROVED IMAGING AND METHOD OF FABRICATING PHASE SHIFTERS WITH ABSORBING/ATTENUATING SIDEWALLS**
PHASENVERSCHIEBUNGSMASKENSTRUKTUR MIT LICHTABSORBIERENDEN/LICHTDÄMPFENDEN SEITENWÄNDEN UND VERFAHREN ZUM AUFBAUEN VON PHASENVERSCHIEBERN
STRUCTURE DE MASQUE DE DEPHASAGE A PAROIS LATERALES ABSORBANTES/ATTENUANTES POUR FORMATION D'IMAGES AMELIOREE ET PROCEDE DE FABRICATION DE DEPHASEURS A PAROIS LATERALES ABSORBANTES/ATTENUANTES

(30) Priority: 21.01.1993 US 7638; 21.01.1993 US 7640
(43) Date of publication of application: 08.11.1995
(73) Proprietor: SEMATECH, INC., Austin, TX 78741-6499 (US)
(72) Inventor: VASUDEV, Prahalad, K., Austin, TX 78746 (US); LOW, Kah, Kuen, Austin, TX 78746 (US)
(74) Representative: Popp, Eugen, Dr.
(86) International application number: US9312094
(87) International publication number: WO9417450

(56) References cited:
- EP-A- 0 395 425
- EP-A- 0 475 694
- JP-A- 3 252 659
- US-A- 4 119 483
- US-A- 5 045 417
- US-A- 5 219 686
- PATENT ABSTRACTS OF JAPAN vol. 17, no. 257 (E-1368)20 May 1993 & JP,A,05 003 146 (HITACHI LTD) 8 January 1993
- IBM TECHNICAL DISCLOSURE BULLETIN. vol. 29, no. 3 , August 1986 , NEW YORK US page 1328 'METHOD TO PRODUCE SIZES IN OPENINGS IN PHOTO IMAGES SMALLER THAN LITHOGRAPHIC MINIMUM SIZE'
- IBM TECHNICAL DISCLOSURE BULLETIN. vol. 25, no. 12 , May 1983 , NEW YORK US pages 6408 - 6414 'OPTICAL RECORDING DISC SYSTEM AND MEMORY MEDIUM'
- INTERNATIONAL CONFERENCE ON MICROLITHOGRAPHY, ROME, ITALY, 17-19 SEPT. 1991, 79 - 85 ISSN 0167-9317 pages 79 - 86 Lin B J 'The optimum numerical aperture for attenuated phase-shifting masks'
- PATENT ABSTRACTS OF JAPAN vol. 16, no. 382 (P-14382)14 August 1992 & JP,A,04 123 060 (FUJITSU LTD) 23 April 1992

## Description

### BACKGROUND OF THE INVENTION

### 1. Field of the Invention

The present invention relates to the field of fabricating photomasks for use in the manufacture of semiconductor devices and, more particularly, to the fabrication of phase shifting photomasks for use in submicron lithography techniques.

### 2. Prior Art

Various techniques are known in the prior art for manufacturing devices on a semiconductor wafer, such as a silicon wafer. Typically, lithography processes are utilized to overlay a pattern(s) onto the wafer. Each pattern provides for selected portions of the wafer to undergo a particular lithographic process, such as deposition, etch, implant, etc. Photomasks (masks) are generally utilized to overlay a particular pattern on the wafer or a layer formed on the wafer. Generally a number of these masks are required for manufacturing a complete device on the wafer.

The earlier prior art lithography techniques rely upon optical techniques in which light is passed through a mask to overlay a pattern on the wafer. Generally, a pattern on the mask equated to a pattern design appearing on the surface of the wafer. However, as the semiconductor technology evolved to allow ever smaller device structures to be fabricated on a wafer, it became increasingly difficult to continue to use the standard optical techniques. It is generally theorized that as device features approach submicron dimensions of 0.25 microns and below, alternative techniques would be required to project patterns onto a wafer.

Due to the limitation imposed by the wavelength of light, resolution at the edges of these patterns tend to degrade when ordinary optical techniques are employed. Standard optical techniques utilizing ultra violet (UV) light will extend the lower range, but still fall short of desired resolution at extremely low ranges (under 0.25 microns). It was generally believed that technologies employing shorter wavelength would ultimately be required for lithography. A number of approaches have been suggested with x-ray lithography being viewed as the technology for use at these low submicron ranges.

However, recent experimentation in the area of phase shifting masks (PSMs) have shown that the PSM technology can be employed to extend the range of optical techniques currently being utilized. That is, the current I-line (at a wavelength of 356 nanometers) and deep ultra violet, or DUV (at a wavelength of 248 nanometers), optical photolithography techniques can be used with the phase shifting photomasks to provide the requisite resolution with sufficient depth of focus for fabricating semiconductor devices having dimensions in the order of .25 microns and below. It is believed that resolutions in the order of 0.1 micron resolution levels can be obtained with sufficient focus latitude by the use of ordinary lithography techniques when phase shifting techniques are applied.

It is generally understood that the technique for improving resolution in photolithography by the use of phase-shifting masks was first proposed by Levenson et al., ("Improving Resolution in Photolithography with a Phase-Shifting Mask", IEEE Transactions on Electron Devices, Vol. ED-29, No. 12, December 1982, pp. 1828-1836) and later implemented by Terasawa et al. ("0.3-micron optical lithography using a phase-shifting mask", Proceedings of SPIE, Vol. 1088 Optical/Laser Microlithography II, 1989, pp. 25-32).

The conventional PSM comprises of creating phase shifting regions in the transparent areas of a photomask. These phase-shifting regions are formed either by depositing transparent films of appropriate thickness and then patterning them over the desired transparent areas using a second level lithography and etch technique or by etching vertical trenches into the quartz substrate. In both of these instances, the "edges" or ("walls") between the phase shifted and unshifted regions mostly result in a transition between high and low refractive index regions.

This sharp transition of the refractive index and the three dimensional structure cause scattering of light due to internal reflections at the edges and causes the transmitted light intensity and spatial profile to vary between the shifted region and the unshifted region and leads to the "waveguiding" effect. The "waveguiding" effect results in the "funnelling" of light into a narrower region in the "phase shifted" areas thereby causing nonuniformity in the aerial image spatial profiles. Consequently, the imaging characteristics of conventional PSMs and uniformity of line- widths are degraded and is less than optimum. This degradation in linewidth uniformity also leads to problems with maintaining a desired aerial image in exposure characteristics across an entire field.

It is appreciated that a technique that would reduce the scattering of light at the transition regions and eliminate the waveguiding effect would provide for a PSM having improved image and exposure characteristics, as well as maintaining a desired uniformity of linewidths across the entire printed image field.

### SUMMARY OF THE INVENTION

A PSM structure having absorbing/attenuating sidewalls along the shifter region in order to improve resolution, linewidth uniformity and depth of focus is described. The PSM of the present invention utilizes shifters in which trenches are formed in a substrate to provide the phase shift.

Once the trenches are patterned and formed in the quartz, the sidewalls of the trenches are coated with a thin film of a light absorbing or attenuating conductive material. The scattering effect experienced at these edges in the prior art PSM are now reduced or eliminated due to the absorption of the light by the sidewalls in the PSM of the present invention. This absorption of light at the sidewalls also creates a "lossy" waveguide thereby eliminating the resonances and hence eliminating the waveguiding effect.

Further, a method of fabricating phase shifters with absorbing/attenuating sidewalls in order to improve resolution, linewidth uniformity and depth of focus in a PSM is described.

After the trenches are patterned and formed, a conformal metal layer is deposited over the substrate, including the trench regions. Then, anisotropic dry etching removes the metal layer except for the vertical area adjacent to sidewalls of the trenches. The absorbing/attenuating sidewall inhibits or prevents scattering of light at the sidewall region when light transitions across the quartz-air interface of the PSM. The absorbing sidewall is shown being formed on an unattenuating PSM and on a Levenson-type PSM. However, it is applicable to other types of PSM as well.

In an alternative method, the conformal metal layer is deposited prior to the removal of the patterned photoresist. Then, a "lift-off" technique is used in which the photoresist is removed by dissolution using a shaking or an agitating action in a liquid solvent. The metal layer overlying the photoresist is removed along with the photoresist breaking away from the entire film so that only the metal layer in the trenches remain.

### BRIEF DESCRIPTION OF THE DRAWINGS

Figure 1A is a cross-sectional diagram showing a prior art PSM using a quartz substrate with trenches formed therein as shifters.

Figure 1B is a cross-sectional diagram of the PSM of Figure 1A and showing transmission of light therethrough, including the scattering experienced at edges of the trench.

Figure 2A is a cross-sectional diagram showing a PSM of the present invention in which a light absorbing sidewall is formed in trench regions to reduce the scattering.

Figure 2B is a cross-sectional diagram of the PSM of Figure 2A and showing transmission of light therethrough, including the absorption at the trench sidewalls.

Figure 3 is a graphic illustration comparing light intensity profiles for the PSMs shown in Figures 1 and 2.

Figure 4A is a cross-sectional diagram showing a quartz substrate used in forming an unattenuated PSM of the present invention.

Figure 4B is a cross-sectional diagram showing a formation of patterned photoresist atop the substrate of Figure 4A.

Figure 4C is a cross-sectional diagram showing a formation of trenches in the substrate of Figure 4B which are utilized to form "shifter" regions.

Figure 4D is a cross-sectional diagram showing a formation of a conforming metal layer over the substrate once the photoresist is removed from the illustration of Figure 4C.

Figure 4E is a cross-sectional diagram showing absorbing sidewalls once the metal layer of Figure 4D is anisotropically etched.

Figure 5A is a cross-sectional diagram showing chromium blanks atop a quartz substrate used in forming a Levenson type PSM of the present invention.

Figure 5B is a cross-sectional diagram showing a formation of a patterned photoresist atop the substrate and the blanks of Figure 5A.

Figure 5C is a cross-sectional diagram showing a formation of a trench in the substrate of Figure 5B which is utilized to form a "shifter" region.

Figure 5D is a cross-sectional diagram showing a formation of a conforming metal layer over the substrate once the photoresist is removed from the illustration of Figure 5C.

Figure 5E is a cross-sectional diagram showing absorbing sidewalls once the metal layer of Figure 5D is anisotropically etched.

Figure 6A is a cross-sectional diagram showing trench formation after photo resist patterning in fabricating an unattenuated PSM.

Figure 6B is a cross-sectional diagram showing a formation of a conforming metal layer over the substrate and photoresist of Figure 6A.

Figure 6C is a cross-sectional diagram showing the remaining metal layer in the shifter trenches after a "lift-off" process is used to remove the photoresist of Figure 6B.

Figure 7A is a cross-sectional diagram showing trench formation after photoresist patterning in fabricating a Levenson type PSM.

Figure 7B is a cross-sectional diagram showing a formation of a conforming metal layer over the substrate, blanks and photoresist of Figure 7A.

Figure 7C is a cross-sectional diagram showing the remaining metal layer in the shifter trench after "lift-off" process is used to remove the photoresist of Figure 7B.

### DETAILED DESCRIPTION OF THE PREFERRED EMBODIMENT

A phase shifting mask (PSM) with light absorbing or attenuating sidewalls is described. In the following description, numerous specific details are set forth, such as specific structures, layers, materials, etc., in order to provide a thorough understanding of the present invention. However, it will be obvious to one skilled in the art that the present invention may be practiced without these specific details. In other instances, well known processes and structures have not been described in detail in order not to unnecessarily obscure the present invention.

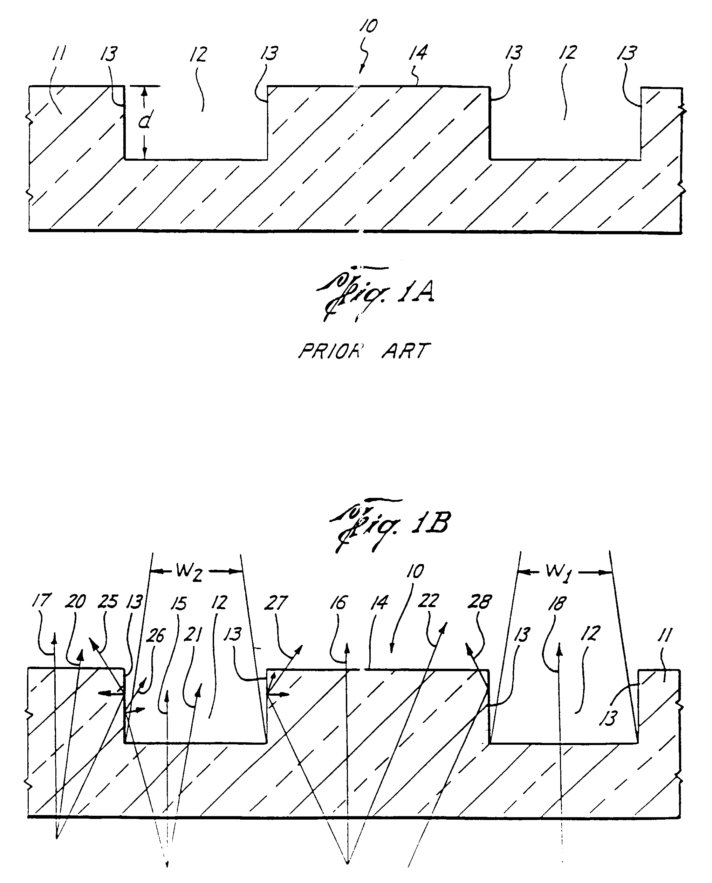

Referring to Figures 1A and 1B, a prior art conventional phase shifting mask (PSM) 10 utilizing a vertical trench as a shifter is shown. PSM 10 is a simple unattenuated mask having a glass or quartz substrate 11 with openings 12 (which are also commonly referred to as trenches) formed in quartz 11. The region formed by each trench 12 provides sidewalls 13 which have a specified vertical depth denoted as distance "d" in Figure 1A. The open trench 12 is typically in air, which has an index of refraction of 1.0, while the quartz substrate 11 typically has an index of refraction of approximately 1.5. Light traversing through substrate 11 and trench 12 (denoted by light ray 15 in Figure 1B) will be out of phase in comparison to a light ray traversing completely through substrate 11 (as denoted by ray 16 in Figure 1B). That is, the phase of light ray 15 is shifted by some phase angle (usually 180°) when compared to the phase of ray 16. The resulting phase shift is achieved by the presence of trench 12. Therefore, each trench 12 functions as the phase shifter and is typically referred to as a "shifter" for the prior art PSM 10.

In Figure 1B, the "edge" and "edge scattering" problem associated with prior art PSM 10, leading to undesirable internal reflections, is exemplified. Light rays, such as rays 15-18 traverse through mask 10 at a substantially perpendicular angle to the transitioning edge 14 of mask 10. These rays 15-18 have the minimum scattering effects. Even rays which are not normal to edge 14, such as rays 20-22, provide minimum of scattering effects. However, light rays, such as rays 25-28, which reach the sidewalls 13 can result in considerable scattering due to the angle of incidence of light striking the edge formed by the sidewalls. At times, this edge scattering can result in significant degradation to the lithography resolution, thereby noticeably affecting the image and exposure characteristics.

Furthermore, the scattering at the edges can cause nonuniformity in linewidths of the printed image. For example, in Figure 1B, distortions in the linewidth of the printed image due to distortions from the shifter regions, are shown as widths w₁ and w₂ and are the result of edge scattering and "waveguiding" effects. These distortions, depicted by w₁ and w₂, can then result in nonuniformity of the lines projected on the printed image.

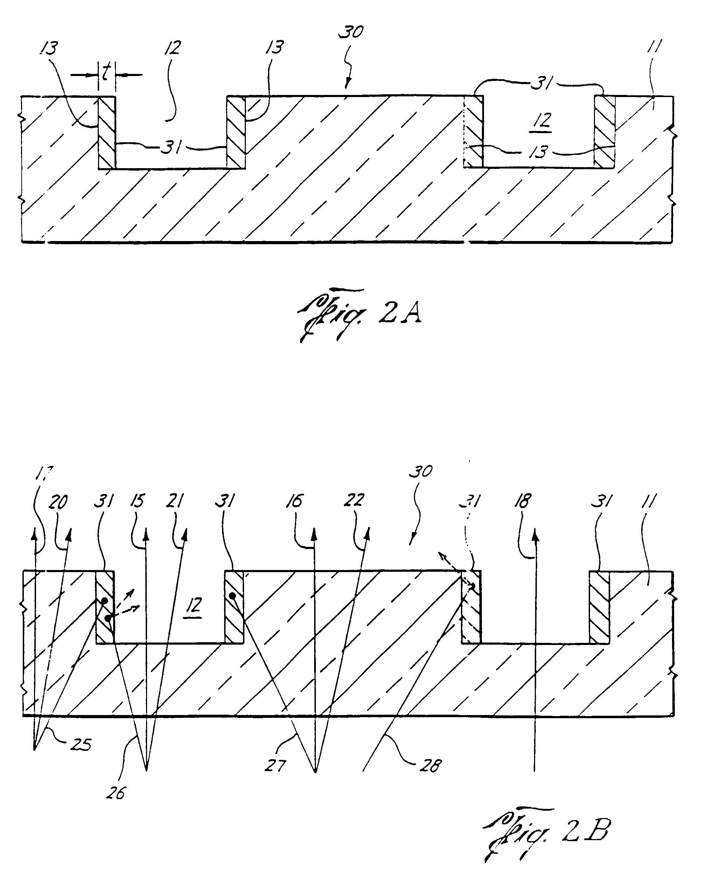

Referring to Figures 2A and B, a phase shifting mask 30 of the present invention is shown. PSM 30 is formed similarly to that of the prior art mask described in Figures 1A-B, however, mask 30 now includes a light absorbing or attenuating sidewall 31 to address the scattering problem noted with the prior art PSM 10 of Figures 1A-B. The absorbing/attenuating sidewall 31 is disposed along the vertical ("sidewall") portion of trench 12. The absorbing/attenuating sidewall 31 is formed from a conducting material in order to provide a conducting region to fully absorb or attenuate (partially absorb in order to attenuate) light rays penetrating the sidewall. This aspect of the invention is better illustrated in Figure 2B.

Using the same reference numerals associated with the light rays depicted in Figure 1B, Figure 2B shows what actually happens to the light rays 25-28 which impact the sidewall 31. Instead of scattering due to the edge effects of the sidewall, these rays 25-28 are substantially absorbed by the absorbing sidewall 31. The light is fully absorbed (shown by rays 25 and 27) or partially absorbed so that the light is attenuated (shown by rays 26 and 28). The absorption of light by absorbing sidewalls 31 altogether prevents or reduces the scattering problem encountered with the prior art PSM 10. Thus, it prevents or inhibits total internal reflections and especially for partially coherent illumination, eliminates the "waveguiding" effects by creating "lossy" sidewalls which suppress resonances on the shifted regions. The elimination of waveguiding using "lossy" sidewalls also makes the spatial profiles independent of shifter width or depth (i.e., removes geometrical dependance).

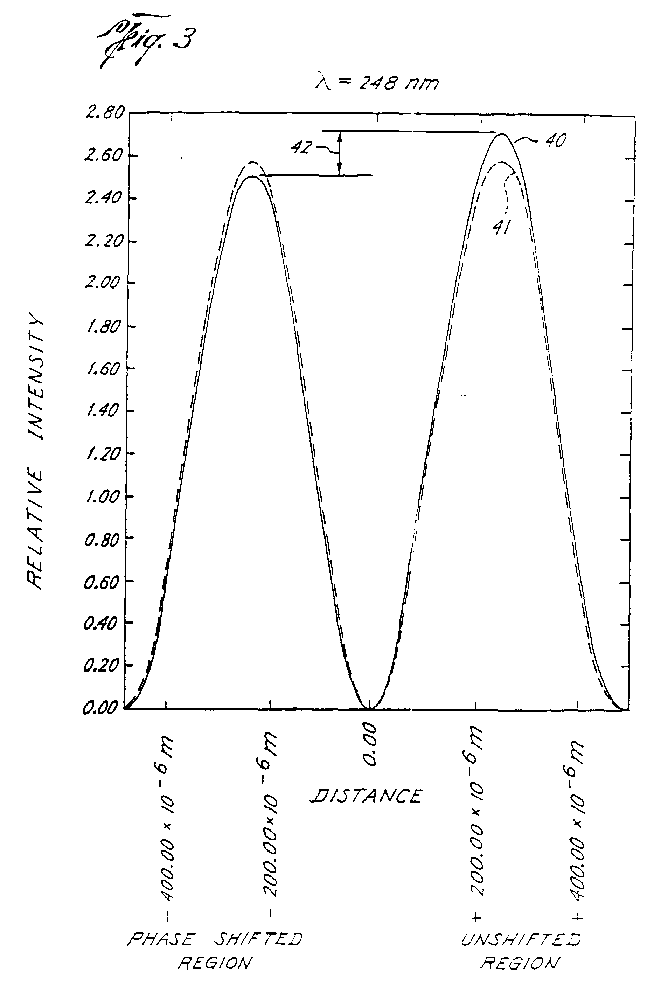

Referring to Figure 3, a graphic illustration comparing the light intensity between the phase shifted and unshifted regions for the conventional PSM 10 and PSM 30 of the present invention utilizing the absorbing sidewall 31 is shown. On the abscissa, distance left of the origin depict the phase-shifted region (i.e., the presence of trench 12), while the unshifted region (i.e., absence of trench 12) is depicted to the right of the origin. The edge is shown as the origin with distances shown in 10⁻⁶ meters. The ordinate provides the amplitude of relative light intensity.

Two conditions are shown in the graph of Figure 3. Curve 40 shows the intensity profile of the aerial image projected onto the target, such as a semiconductor wafer without the absorbing sidewall 31, while curve 41 shows equivalent intensity profile but with the presence of the absorbing sidewall 31. Without the absorbing/attenuating sidewall 31, the prior art PSM 10 results in the difference 42 of the two intensity profiles. This difference can degrade the resolution and/or the depth of focus of the aerial image as well as causing a nonuniformity of linewidth in the printed image. However, with the absorbing sidewall 31, the PSM 30 of the present invention is shown having fairly equal intensity profiles for both the phase-shifted and unshifted regions.

The particular example of Figure 3 is that of a chromeless glass PSM operating at DUV wavelength of 245 nm with 5x magnification where σ (partial coherence) = 0, NA (numerical aperture) = 0.5 and df (depth of focus) = 0. The material for the absorbing sidewall 31 is chromium (Cr) having a thickness t of approximately 200 angstroms.

It is to be noted that a variety of conducting materials can be readily utilized to form the absorbing/attenuating sidewall 31 of the present invention. However the preferred material is metal, metal alloy or silicide. The design criteria is that the absorbing factor (K) of the metallic material, which is known by K=4πσ/λ, where σ is electrical conductivity and λ is the wavelength of light, should be such that the incoming light intensity (Iₒ) is reduced to 1/e of its value within a thickness t (t being the thickness of the absorbing sidewall 31 as is noted in Figure 2A). The thickness t is commonly referred to as the "skin" depth and typical values vary within a range of 100 to 500 angstroms for most conducting materials over the wavelength range from deep ultraviolet to I-line and thereby can be present without significantly perturbing the forward transmission characteristics of the PSM 30.

It is to be appreciated that various light absorbing materials which are typically conducting materials, can be utilized for the absorbing sidewall 31 of the present invention, as is noted in the description above. Typical example materials are molybdenum, chromium, aluminum and gold, as well as their alloys and silicides. Silicon can also be utilized but provides less absorption than metals for comparable thicknesses. An advantage of using silicon is that it is easier to deposit and etch than metallic materials and the thickness control is less stringent. The thickness t of these materials should be of appropriate value to allow sufficient absorption of light at the wavelength of interest for a given light intensity, as was noted above. For metals, thickness t would be toward the lower end of the range (100 angstroms) while thickness t for silicon will be toward the middle and upper end of the range (300 - 500 angstroms).

The presence of such a metallic or silicon coating along the sidewall of trench 12 provides for a number of advantages. These advantages include improving the imaging characteristics of the PSM by reducing sidewall scattering, reducing "waveguiding" effects, improving resolution, and improving the depth of focus (by making the aerial image conform closer to the ideal. Other advantages include improving repairability of masks in a repair system (such as a Focussed Ion Beam or Laser Repair System) by providing a conductive coating at edges and improving edge detection and contrast in inspection systems. The conductive layer provides an etch "stop" for stopping the ion beam milling process with excellent selectivity.

The reason for this is that the optical "contrast" in an ion-beam mask repair system is significantly enhanced by a glass-to-metal transition than a glass-to-glass transition. Furthermore, the PSM 30 of the present invention is fairly easy to fabricate.

It is to be appreciated that although a particular PSM 30 has been described herein, absorbing sidewalls 31 using conductive and semiconductive materials can be readily implemented in a variety of situations involving PSMs. It is to be further appreciated that although PSM 30 is shown as a conventional unattenuated PSM, the present invention can be readily utilized with other types of PSMs, such as Levenson, Rim, subresolution and attenuated PSMs, without departing from the scope and spirit of the present invention. Thus, this invention can be readily extended to deposited film shifters as well.

A number of techniques can be utilized to form the absorbing/attenuating sidewall 31. Metallic, as well as silicon material can be deposited into the trench 12 of the prior art PSM 10 and anisotropically etched in order to form the absorbing sidewall 31 of the present invention. However, the preferred method for forming such an absorbing sidewall is disclosed below.

A method for fabricating phase shifters with absorbing or attenuating sidewalls using an additive process is described. In the following description, numerous specific details are set forth, such as specific structures, layers, materials, etc., in order to provide a thorough understanding of the present invention. However, it will be obvious to one skilled in the art that the present invention may be practiced without these specific details. In other instances, well-known processes and structures have not been described in detail in order not to unnecessarily obscure the present invention.

Furthermore, the method described herein can be readily adapted for forming a variety of light absorbing or attenuating layers, but the preferred application is for the purpose of forming light absorbing/attenuating sidewalls along trench sidewalls of phase shifting masks (PSMs). A PSM utilizing a trench shifter which includes a light absorbing/attenuating sidewall has been described above.

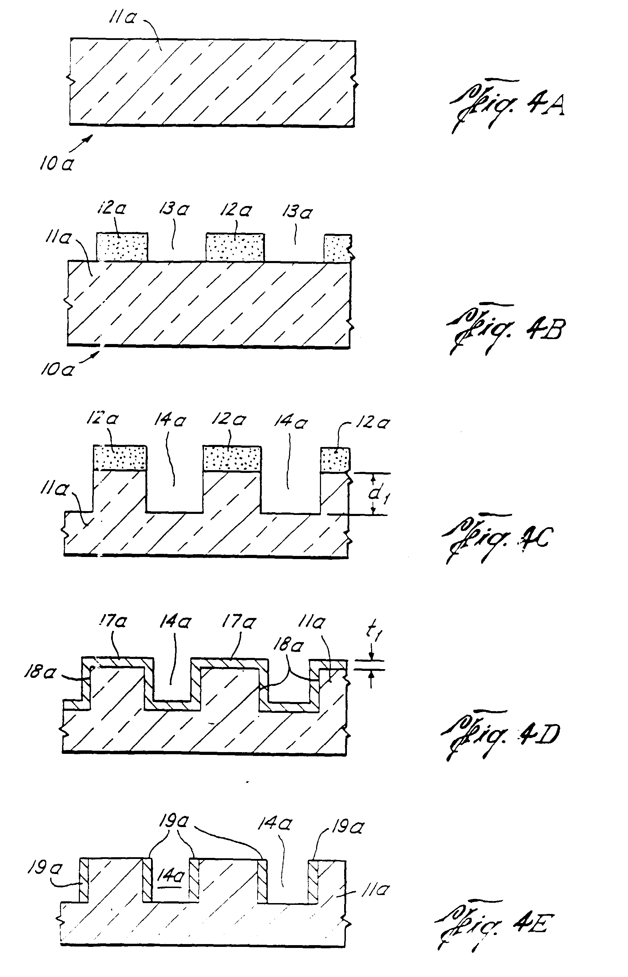

Referring to Figures 4A-E, a method for forming a phase shifter having conducting sidewalls for light absorption or attenuation in an unattenuated photomask is illustrated. The unattenuated photomask 10a is formed from a quartz substrate 11a which generally has an index of refraction of 1.5. Then, a layer of photoresist 12a is formed on the quartz substrate 11a, and patterned using standard lithography techniques in order to form patterned openings 13a which expose the underlying substrate 11a. Subsequently, a dry etching process (preferably one using a fluorine chemistry), such as a process utilizing carbon tetrafluoride (CF₄) plasma, is used to etch an opening 14a (also referred to as a trench) into substrate 11a to a depth "d₁" as noted in Figure 4C.

Trench 14a cuts into the substrate 11a and thereby forms a phase shifter of mask 10a. Then, the remaining photoresist 12a is then stripped. Afterwards, a thin film layer of metallic absorber material 17a is conformally deposited over the substrate 11a and trench 14a, as shown in Figure 4d. Sidewalls 18a of trench 14a also are covered by the metallic material 17a. Typically, thickness t₁ of the metallic absorbing layer 17a is in the order of approximately 100 to 500 angstroms. Conformal deposition of layer 17a can be readily achieved by chemical vapor deposition (CVD), sputtering (such as collimated sputtering) or by evaporation of metal.

Finally, a subsequent etching technique, such as a sputter etch in argon (Ar⁺) plasma or, alternatively, an reactive ion etching (RIE) technique using Chlorine or the appropriate chemistry is used to anisotropically remove the metallic film 17a, including the film located at the bottom of the trench. The anisotropic etching removes all of metal layer 17a except for a portion adjacent to sidewalls 18a due to its vertical profile. Thus, an edge coating remains along the sidewalls 18a forming absorbing/attenuating sidewall layer 17a within trench 14a. This type of anisotropic etching occurs naturally in RIE etch equipment. The RIE etch process adjusted for the metal film stops on the quartz substrate lla such that precise control of etching time or introduction of etch stops are not required. In sputter etching, the selectivity is high due to the considerable difference in the sputter rates of metal versus quartz. Thus, the resultant absorbing sidewall 19a for preventing or reducing (attenuating) edge scattering at the sidewall is formed.

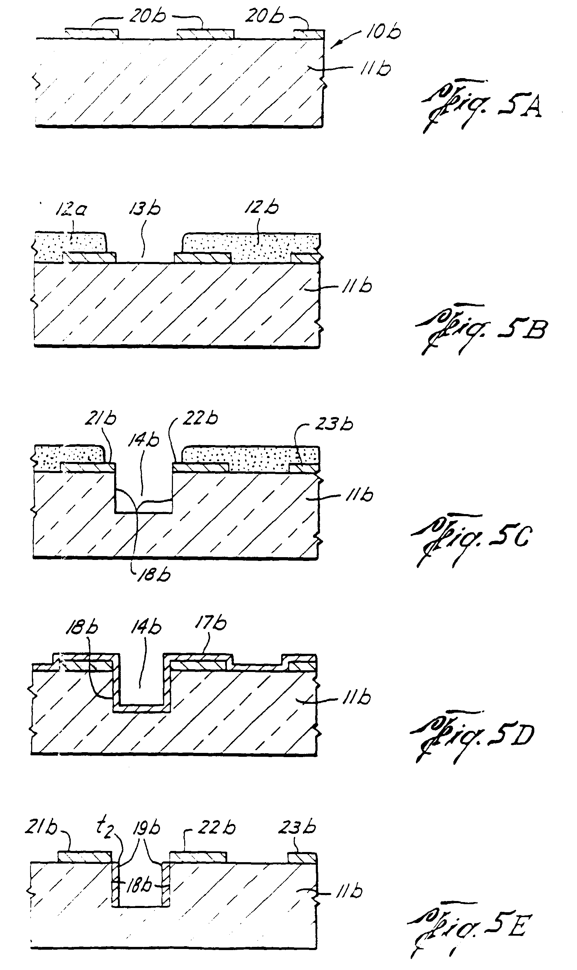

Referring to Figures 5A-E, a formation of a light absorbing/attenuating sidewall on an Levenson-type PSM 10b is described. The process is similar to that described in reference to unattenuated PSM 10a of Figures 4A-E with the difference that the Levenson PSM 10b employs chromium (Cr) regions 20b atop the quartz. These chromium regions (blanks) 20b are also referred to as opaque regions in standard binary intensity masks. The formation of a chromium film of approximately 1000-2500 angstroms is formed and patterned on the quartz substrate 11b. As in the earlier process, a photoresist is formed over the substrate 11b and chromium opaque region 20b. However, as is noted in Figure 5B, it is not critical to have the edge of the photoresist define the location of trench 14b since the edges of the chromium blank 20b will define the edge location by self-alignment. In the particular example of Figure 5B, photoresist 12b is patterned to have an opening 13b only between two of the chromium blanks 21b and 22b, while the photoresist layer 12b completely covers the other separation between the chromium blanks 22b and 23b.

Subsequently, using a dry-etch process, trench 14b is formed into quartz 11b. The sidewalls 18b of trench 14b are aligned with the edge of the two chromium blanks 21b and 22b. Due to the presence of the photoresist 12b an opening is not formed between chromium blanks 22b and 23b. Next, the photoresist layer 12b is removed by using a strip process. Then the conforming metal layer 17b is deposited over both the substrate 11b, including trench 14b, and over chromium blanks 20b by one of the processes described earlier. Then using either of the sputter etch or the RIE etch techniques, metal film 17b is anisotropically removed leaving a metal layer 17b only adjacent to vertical sidewalls 18b to form absorbing sidewalls 19b. Thus, absorbing/attenuating sidewalls 19b are formed within trench 14b and only adjacent to the sidewalls 18b. The thickness t₂ of the sidewalls 19b are equivalent to that of t₁, earlier described.

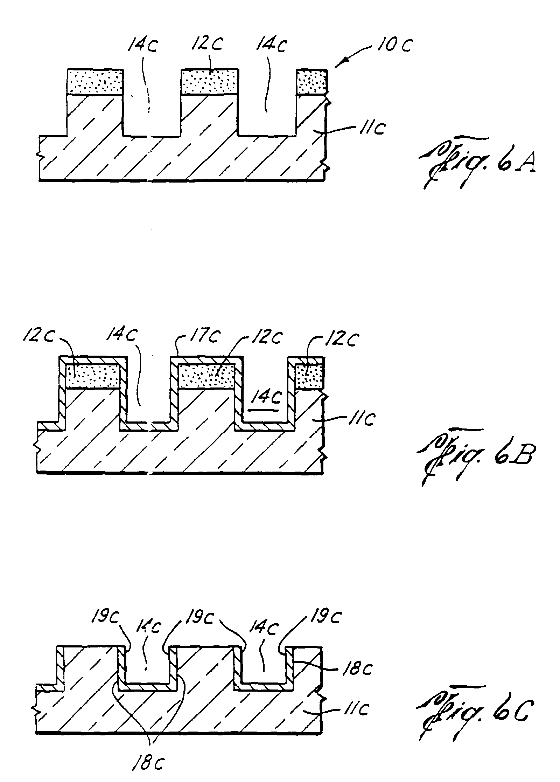

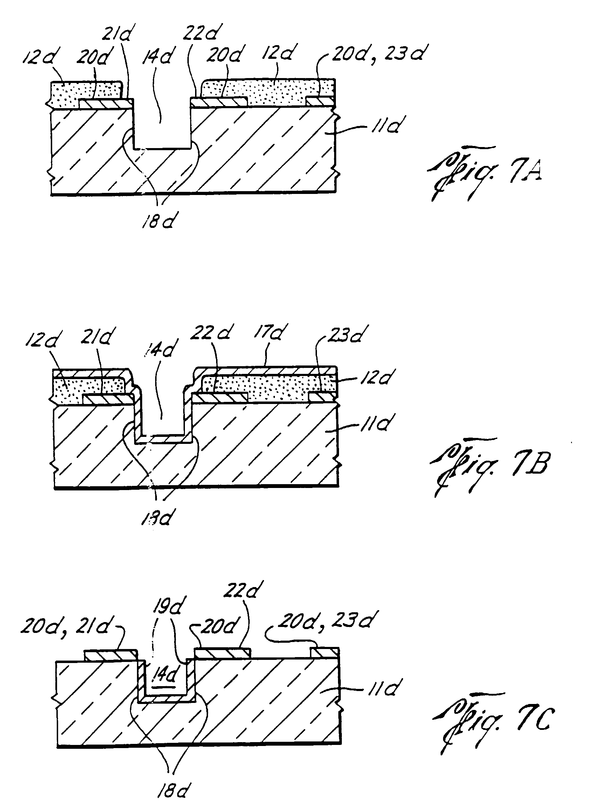

Referring to Figures 6A-C and 7A-C, methods for forming an absorbing sidewall using an alternative "lift-off" process for the unattenuated and Levenson-type PSMs are shown. In Figure 6A, trench opening 14c is formed in substrate 11c by the process described in reference to Figures 4A-1C. Subsequently, instead of removing the photoresist 12c, metal film layer 17c is deposited over both the photoresist 12c and substrate 11c at or near room temperature. The conformal metal layer is deposited by collimated sputtering as shown in Figure 6B.

Next, the photoresist 12c is dissolved in a hot developer (or other liquid solvent) while a shaking or agitating force is used to break the photoresist 12c and metal film 17c located atop the photoresist 12c. The photoresist 12c and its overlying metal film 17c breaks and is dislodged from the quartz 11c. As is noted in Figure 6C, once the photoresist 12c and the overlying metal layer 17c are removed, only the metallic coating within trenches 14c remain. Thus, the phase shifters of PSM 10c formed by trenches 14c will have a metallic layer 17c on the entire shifter surface, and not only along the sidewalls 18c.

It is to be noted that the "lift-off" process can be utilized when the film has a thickness toward the lower end of the range. It is preferred that the thickness of metal film 17c be kept at under 150 angstroms for the "lift-off" method to be used. Because of this smaller thickness, absorption of light at the bottom of the trench (due to the bottom film layer) is kept to a minimum.

Figures 7A-C show a similar process but on the Levenson-type PSM 10d which employs chromium blanks 20d. A photoresist layer 12d is formed overlying portions of substrate 11d and blanks 20d. Again, as was noted earlier in reference to Figures 5A-E, the actual location of the edge of the photoresist 12d defining the trench 14d is not as critical in the Levenson-type PSM since pads 21d and 22d define the sidewalls 18d for trench 14d. Figure 7A shows the process as described in reference to Figures 5A-C.

Subsequently, prior to the removal of the photoresist 12d, a metal film layer 17d is deposited above substrate 11d, chromium blanks 20d and photoresist 12d, as is shown in Figure 7B. Again, the resist is dissolved in a hot developer with the aid of a shaking or agitating action to break the photoresist 12d and metal film 17d overlying the photoresist 12d. The removal of the photoresist 12d and the overlying metal layer 17d essentially leaves only the metal conformal layer within trench 14d. Thus, the metal layer 17d is present along the sidewalls 18d and at the base of the trench 14d which forms the shifter portion of the PSM 10d. Again, this "lift-off" process is available for film thicknesses of under 150 angstroms.

The various types of materials for use in forming the absorbing sidewall 19a-d is a design choice and is noted above. Preferred materials are conducting materials, such as molybdenum, chromium, aluminum, gold, their alloys and silicides. Silicon can also be utilized, but its thickness must be appropriately designed.

It is to be appreciated that absorbing/attenuating sidewalls can be readily implemented in variety of situations involving PSMs. It is to be further appreciated that the present invention can be readily utilized with other types of PSMs, such as Rim, subresolution and attenuated PSMs, without departing from the scope and spirit of the present invention. For example, in the case of attenuating PSMs, the method described herein can be used for both the opaque regions as well as sidewall absorbers in a single lithography step.

Thus, a phase shifting mask structure with absorbing/attenuating sidewalls for improved imaging is described and a method of fabricating a phase shifting mask invention with absorbing/attenuating sidewalls or attenuating phase shifters for improved imaging is described.

## Claims

1. A photolithography mask having phase shifting regions disposed thereon for phase shifting incident light transmission therethrough as compared to light transmission through other nonshifting regions, said mask comprising:
a substrate (11) having vertical trenches (12) formed therein, said trenches defining said phase shifting regions and having vertical sidewalls which delineate a separation between said phase shifting and nonshifting regions; .
thin film conductive layers (31) formed along sidewalls (13) of said vertical trenches (12) for absorbing or attenuating light energy impinging on said sidewalls (13);
wherein said thin film conductive layers (31) in operation of the photomask inhibit the scattering of light within the phase shifting regions in order to improve resolution of a projected image field.

2. The photolithography mask of Claim 1, wherein the thin film layers have a thickness in the range of 10 to 50 nm (100 to 500 Angstroms).

3. The photolithography mask of Claim 1 or 2, wherein said thin film layers (31) are formed from a metallic material.

4. The photolithography mask of Claim 1 or 2, wherein said thin film layers (31) are formed from a material selected from the group consisting of molybdenum, chromium, aluminum, gold, their alloys and their silicides.

5. The photolithography mask of Claim 1 or 2, wherein said thin film layers (31) are formed from silicon.

6. The photolithography mask of one of the Claims 1 to 5, wherein said substrate is formed from a dielectric material.

7. A method of fabricating a phase shifting photomask comprising the steps of:
forming a patterned photoresist layer (12a) over a substrate (11) in which patterned openings (13a) expose portions of said underlying substrate;
etching said exposed portions of said substrate to form vertical trenches (14a) in said substrate, said trenches functioning as phase shifting regions of said photomask providing a phase difference of incident light transmitted therethrough as compared to light transmission through other nonshifting regions, said trenches having vertical sidewalls which delineate a separation between said phase shifting and nonshifting regions;
removing said photoresist layer (12a);
depositing a thin film conductive layer (17a) over said substrate and covering sidewall surfaces of said vertical trenches (14a);
etching said thin film conductive layer (17a) such that said thin film layer substantially remains only on said sidewall surfaces (18a) of said trenches;
wherein said thin film layer in operation of the photomask absorbs at least a portion of light energy impinging on said sidewalls in order to inhibit light scattering at said sidewalls such that resolution of a projected image field of said photomask is improved.

8. The method of Claim 7, wherein the thin film layer on the sidewalls has a thickness in the range of 10 to 50 nm (100 to 500 Angstroms).

9. The method of Claim 7 or 8, wherein said thin film layer (17a) is formed from a metallic material.

10. The method of Claim 7 or 8, wherein said thin film layer (17a) is formed from a silicon material.

11. The method of one of the Claims 7 to 10, wherein the step of forming a patterned photoresist layer is performed over a substrate having opaque regions (20b) disposed thereon, the opaque regions (20b) having previously been formed and patterned on the substrate.

12. A method of fabricating a phase shifting photomask comprising the steps of:
forming a patterned photoresist layer (12c) over a substrate in which patterned openings expose portions of said underlying substrate (11);
etching said exposed portions of said substrate (11) to form vertical trenches (14c) in said substrate,
said trenches functioning as phase shifting regions of said photomask providing a phase difference of incident light transmitted therethrough as compared to light transmission through other nonshifting regions, said trenches having vertical sidewalls which delineate a separation between said phase shifting and nonshifting regions;
depositing a thin film conductive layer (17c) over said photosensitive layer (12c) and said substrate (11), and covering sidewall surfaces of said vertical trenches (14c);
agitating in a liquid solvent to dislodge said patterned photosensitive layer (12c) which removal also dislodges portions of said thin film layer (17c) overlying said photosensitive layer such that said thin film layer substantially remains only in said vertical trenches;
wherein said thin film layer in operation of the photomask absorbs at least a portion of light energy impinging on sidewalls (18c) of said vertical trenches in order to inhibit light scattering at said sidewalls such that resolution of a projected image field of said photomask is improved.

13. The method of Claim 12, wherein the thin film layer has a thickness in the range of 10 to 50 nm (100 to 500 Angstroms).

14. The method of Claim 12 or 13, wherein said thin film layer (17c) is formed from a metallic material.

15. The method of Claim 12 or 13, wherein said thin film layer (17c) is formed from a silicon material.

16. The method of one of the Claims 12 to 15, wherein the step of forming a patterned photoresist layer is performed over a substrate having opaque regions (20d) disposed thereon, the opaque regions (20d) having previously been formed and patterned on the substrate.

## Patentansprüche

1. Photolithographiemaske mit darauf angeordneten phasenverschiebenden Bereichen zum Phasenverschieben einfallenden Lichtes während der Durchtrittes durch diese im Vergleich zu einem Lichtdurchtritt durch andere nicht verschiebende Bereiche, wobei die Maske aufweist:
ein Substrat (11) mit darin ausgebildeten vertikalen Gräben (12), wobei die Gräben die phasenverschiebenden Bereiche definieren und vertikale Wände aufweisen, welche eine Trennung zwischen den phasenverschiebenden und den nicht-verschiebenden Bereichen bezeichnen;
entlang Seitenwänden (13) der vertikalen Gräben (12) ausgebildete leitende dünne Filmschichten (31) zum Absorbieren oder Abschwächen von auf die Seitenwände (13) auftreffender Lichtenergie;
wobei die leitenden dünnen Filmschichten (31) bei der Anwendung der Photomaske die Streuung des Lichtes in den phasenverschiebenden Bereichen verhindern, um die Auflösung eines projizierten Abbildungsfeldes zu verbessern.

2. Photolithographiemaske nach Anspruch 1, wobei die dünnen Filmschichten eine Dicke in dem Bereich von 10 bis 50 nm (100 bis 500 Angström) aufweisen.

3. Photolithographiemaske nach Anspruch 1 oder 2, wobei die dünnen Filmschichten (31) aus einem metallischen Material ausgebildet sind.

4. Photolithographiemaske nach Anspruch 1 oder 2, wobei die dünnen Filmschichten (31) aus einem Material ausgebildet sind, das aus der aus Molybdän, Chrom, Aluminium, Gold, deren Legierungen und deren Siliziden bestehenden Gruppe gewählt wird.

5. Photolithographiemaske nach Anspruch 1 oder 2, wobei die dünnen Filmschichten (31) aus Silizium ausgebildet sind.

6. Photolithographiemaske nach einem der Ansprüche 1 bis 5, wobei das Substrat aus einem dielektrischen Material ausgebildet ist.

7. Verfahren zum Herstellen einer phasenverschiebenden Photomaske mit den Schritten:
Ausbilden einer strukturierten Photolackschicht (12a) über einem Substrat (11), in welcher strukturierte Öffnungen (13a) Bereiche des darunterliegenden Substrates freilegen;
Ätzen der freigelegten Bereiche des Substrates, um vertikale Gräben (14a) in dem Substrat auszubilden, wobei die die Funktion phasenverschiebender Bereiche aufweisenden Gräben der Photomaske eine Phasenverschiebung an dem dadurch hindurchgetretenen einfallenden Licht im Vergleich zu einem Lichtdurchtritt durch andere nicht verschiebende Bereich erzeugt, und die Gräben vertikale Seitenwände aufweisen, welche eine Trennung zwischen phasenverschiebenden und nicht verschiebenden Bereichen bezeichnen;
Entfernen der Photolackschicht (12a);
Abscheiden einer leitenden dünnen Filmschicht (17a) über dem Substrat und Überdecken der Seitenwandoberflächen der vertikalen Gräben (14a);
Ätzen der leitenden dünnen Filmschicht (17a) in der Weise, daß die dünne Filmschicht im wesentlichen nur auf den Seitenwandoberflächen (18a) der Gräben zurückbleibt;
wobei die dünne Filmschicht bei der Anwendung der Photomaske zumindest einen Teil der auf die Seitenwände auftreffenden Lichtenergie absorbiert, um eine Lichtstreuung an den Seitenwänden in der Weise zu verhindern, daß die Auflösung eines projizierten Abbildungsfeldes der Photomaske verbessert wird.

8. Verfahren nach Anspruch 7, wobei die dünne Filmschicht an den Seitenwänden eine Dicke in dem Bereich von 10 bis 50 nm (100 bis 500 Angström) aufweist.

9. Verfahren nach Anspruch 7 oder 8, wobei die dünne Filmschicht (17a) aus einem metallischen Material ausgebildet ist.

10. Verfahren nach Anspruch 7 oder 8, wobei die dünne Filmschicht(17a) aus einem Siliziummaterial ausgebildet ist.

11. Verfahren nach einem der Ansprüche 7 bis 10, wobei der Schritt der Ausbildung einer strukturierten Photoresistschicht über einem Substrat mit darauf angeordneten undurchsichtigen Bereichen (20b) ausgeführt wird, welche zuvor auf dem Substrat ausgebildet und strukturiert worden sind.

12. Verfahren zum Herstellen einer phasenverschiebenden Photomaske mit den Schritten:
Ausbilden einer strukturierten Photoresistschicht (12c) über einem Substrat, in welcher strukturierte Öffnungen Bereiche des darunterliegenden Substrates (11) freilegen;
Ätzen der freigelegten Bereiche des Substrates (11), um vertikale Gräben (14c) in dem Substrat auszubilden, wobei die die Funktion phasenverschiebender Bereiche aufweisenden Gräben der Photomaske eine Phasenverschiebung an dem dadurch hindurchgetretenen einfallenden Licht im Vergleich zu einem Lichtdurchtritt durch andere nicht verschiebende Bereich erzeugt, und die Gräben vertikale Seitenwände aufweisen, welche eine Trennung zwischen phasenverschiebenden und nicht verschiebenden Bereichen bezeichnen;
Abscheiden einer leitenden dünnen Filmschicht (17c) über der Photoresistschicht (12c) und dem Substrat (11) und Überdecken der Seitenwandoberflächen der vertikalen Gräben (14c);
Bewegen in einem flüssigen Lösungsmittel, um den strukturierten Photoresistschicht (12c) abzulösen, wobei dieser Entfernungsvorgang auch Abschnitte der dünnen Filmschicht (17c), die über der Photoresistschicht liegt, in der Weise ablöst, daß die dünne Filmschicht im wesentlichen nur in den vertikalen Gräben zurückbleibt;
wobei die dünne Filmschicht bei der Anwendung der Photomaske zumindest einen Teil der auf die Seitenwände (18c) auftreffenden Lichtenergie absorbiert, um eine Lichtstreuung an den Seitenwänden in der Weise zu verhindern, daß die Auflösung eines projizierten Abbildungsfeldes der Photomaske verbessert wird.

13. Verfahren nach Anspruch 12, wobei die dünne Filmschicht eine Dicke in dem Bereich von 10 bis 50 nm (100 bis 500 Angström) aufweist.

14. Verfahren nach Anspruch 12 oder 13, wobei die dünne Filmschicht (17c) aus einem metallischen Material ausgebildet ist.

15. Verfahren nach Anspruch 12 oder 13, wobei die dünne Filmschicht (17c) aus einem Siliziummaterial ausgebildet ist.

16. Verfahren nach einem der Ansprüche 12 bis 15, wobei der Schritt der Ausbildung einer strukturierten Photoresistschicht über einem Substrat mit darauf angeordneten undurchsichtigen Bereichen (20d) ausgeführt wird, welche zuvor auf dem Substrat ausgebildet und strukturiert worden sind.

## Revendications

1. Masque de photolithographie ayant des régions de déphasage placées sur celui-ci pour décaler en phase la transmission de lumière incidente par ces régions par rapport à la transmission de lumière par d'autres régions sans déphasage, ledit masque comprenant:
un substrat (11) ayant des rainures verticales (12) formées dans celui-ci, ces rainures définissant lesdites régions de déphasage et ayant des parois verticales qui tracent une séparation entre lesdites régions de déphasage et lesdites régions sans déphasage;
des couches conductrices faites d'un film mince (31), formées le long des parois latérales (13) desdites rainures verticales (12), pour absorber ou atténuer l'énergie lumineuse frappant lesdites parois (13);
dans lequel lesdites couches en film mince, conductrices (31), pendant le fonctionnement du photomasque, empêchent la diffusion de la lumière à l'intérieur des régions de déphasage afin d'améliorer la résolution du champ d'images projetées.

2. Masque de photolithographie selon la revendication 1, dans lequel les couches en film mince ont une épaisseur de 10 à 50 nm (100 à 500 Angströms).

3. Masque de photolithographie selon la revendication 1 ou 2, dans lequel les couches en film mince (31) sont formées dans un matériau métallique.

4. Masque de photolithographie selon la revendication 1 ou 2, dans lequel les couches en film mince (31) sont formées dans un matériau choisi parmi le groupe constitué du molybdène, du chrome, de l'aluminium, de l'or, de leurs alliages et de leurs siliciures.

5. Masque de photolithographie selon la revendication 1 ou 2, dans lequel les couches en film mince (31) sont formées dans du silicium.

6. Masque de photolithographie selon la revendication 1 à 5, dans lequel ledit substrat est formé dans un matériau diélectrique.

7. Méthode de fabrication d'un photomasque à déphasage, comprenant les étapes consistant à:
former une couche photorésistive à motifs (12a) sur un substrat (11) dans laquelle des ouvertures selon ces motifs (13a) découvrent des parties du substrat sous-jacent;
attaquer chimiquement lesdites parties découvertes dudit substrat pour former des rainures verticales (14a) dans ledit substrat, ces rainures fonctionnant comme des régions de déphasage dudit photomasque, créant une différence de phase de la lumière incidente transmise par ces régions comparativement à la lumière transmise au travers de régions sans déphasage, lesdites rainures ayant des parois verticales qui tracent une séparation entre les régions de déphasage et sans déphasage;
retirer ladite couche photorésistive (12a);
déposer une couche conductrice en film mince (17a) sur ledit substrat et recouvrir les surfaces des parois latérales desdites rainures verticales (14a);
attaquer chimiquement ladite couche en film mince conductrice (17a) de façon que cette couche reste sensiblement uniquement sur lesdites surfaces des parois (18a) desdites rainures;
dans laquelle ladite couche en film mince, pendant le fonctionnement du photomasque, absorbe au moins une partie de l'énergie lumineuse frappant lesdites parois latérales de manière à empêcher la diffusion de lumière sur ces parois afin d'améliorer la résolution du champ d'images projetées du photomasque.

8. Méthode selon la revendication 7, dans laquelle la couche en film mince sur les parois latérales a une épaisseur de 10 à 50 nm (100 à 500 Angströms).

9. Méthode selon la revendication 7 ou 8, dans laquelle la couche en film mince (17a) est formée à partir d'un matériau métallique.

10. Méthode selon la revendication 7 ou 8, dans laquelle la couche en film mince (17a) est formée à partir d'un matériau composé de silicium.

11. Méthode selon l'une des revendications 7 à 10, dans laquelle l'étape consistant à former une couche photorésistive à motifs est réalisée sur un substrat ayant des régions opaques (20b) disposées sur celui-ci, ces régions opaques (20b) ayant été auparavant formées et dessinées sur le substrat.

12. Méthode de fabrication d'un photomasque à déphasage, comprenant les étapes consistant à:
former une couche photorésistive à motifs (12c) sur un substrat, dans laquelle des ouvertures selon ces motifs découvrent des parties de ce substrat sous-jacent (11);
attaquer chimiquement lesdites parties découvertes dudit substrat (11) pour former des rainures verticales (14c) dans ledit substrat, lesdites rainures fonctionnant comme des régions de déphasage dudit photomasque, créant une différence de phase de la lumière incidente transmise par ces régions comparativement à la lumière transmise au travers de régions sans déphasage, lesdites rainures ayant des parois verticales qui tracent une séparation entre les régions de déphasage et sans déphasage;
déposer une couche conductrice en film mince (17c) sur ladite couche photorésistive (12c) et ledit substrat (11), et recouvrir les surfaces des parois latérales desdites rainures verticales (14c);
agiter dans un solvant liquide pour déloger ladite couche photorésistive à motifs (12c) dont le retrait déloge aussi des parties de ladite couche en film mince (17c) recouvrant ladite couche photorésistive, de manière à ce que ladite couche en film mince reste sensiblement uniquement dans les rainures verticales;
dans laquelle ladite couche en film mince, pendant le fonctionnement du photomasque, absorbe au moins une partie de l'énergie lumineuse frappant les parois (18c) desdites rainures verticales, de manière à empêcher la diffusion de lumière sur ces parois de sorte que la résolution du champ d'images projetées dudit photomasque soit améliorée.

13. Méthode selon la revendication 12, dans laquelle la couche en film mince a une épaisseur de 10 à 50 nm (100 à 500 Angströms).

14. Méthode selon la revendication 12 ou 13, dans laquelle la couche en film mince (17c) est formée dans un matériau métallique.

15. Méthode selon la revendication 12 ou 13, dans laquelle la couche en film mince (17c) est formée dans un matériau composé de silicium.

16. Méthode selon l'une des revendications 12 à 15, dans laquelle l'étape consistant à former une couche photorésistive à motifs est réalisée sur un substrat ayant des régions opaques (20d) disposées sur celui-ci, ces régions opaques (20d) ayant été auparavant formées et dessinées sur le substrat.
